# EUROPÄISCHE PATENTSCHRIFT

(11) **EP 4 089 843 B1**
(45) Veröffentlichungstag und Bekanntmachung des Hinweises auf die Patenterteilung: **28.10.2026**
(21) Anmeldenummer: 22163512.1
(22) Anmeldetag: 22.03.2022
(51) Int. Cl.: H01R 12/57, H01R 13/11, H01R 9/26, H01R 9/24

(54) **ANSCHLUSSELEMENT ZUM MONTIEREN EINER ELEKTRISCHEN LEITER-PLATTE AN EINEN ELEKTRISCHEN FLACHLEITER**
CONNECTING ELEMENT FOR MOUNTING AN ELECTRICAL FLAT CONDUCTOR TO A PCB
ÉLÉMENT DE CONNEXION PERMETTANT DE MONTER UN CONDUCTEUR ÉLECTRIQUE PLAT SUR UN PCB

(30) Priorität: 11.05.2021 DE 102021112259
(43) Veröffentlichungstag der Anmeldung: 16.11.2022
(73) Patentinhaber: Weidmüller Interface GmbH & Co. KG, 32758 Detmold (DE)
(72) Erfinder: BUSCH, Gerald, 32791 Lage (DE); STUCKMANN, Peter, 32791 Lage (DE); SCHUMACHER, Ralf, 32657 Lemgo (DE); HERMANNS, Kurt, 64823 Groß-Umstadt (DE); WIELSCH, Thomas, 32760 Detmold (DE)
(74) Vertreter: Specht, Peter

(56) Entgegenhaltungen:
- EP-A2- 1 326 304
- DE-A1- 102014 001 272
- DE-A1- 2 422 538
- DE-B3- 102020 104 620
- KR-A- 20170 110 287
- KR-B1- 101 458 621

## Beschreibung

Die vorliegende Erfindung betrifft ein Anschlusselement zum Montieren einer elektrischen Leiterplatte an einen elektrischen Flachleiter, insbesondere eine Stromschiene, nach dem Oberbegriff des Anspruchs 1.

Reihenklemmen werden zum schnellen, einfachen und sicheren Verbinden elektrischer Leiter, insbesondere beim Schaltschrankbau, genutzt. Für die Anpassung an verschiedene Anforderungen und Aufgaben (z. B. Durchgangsreihenklemme, Sicherungsreihenklemme, Schutzleiterreihenklemme, Reihenklemme mit elektronischen Bauteilen etc.) weisen sie neben Anschlussvorrichtungen zum Anschluss elektrischer Leiter (z. b. in Direktstecktechnik, als Schraubanschluss oder in Zugfedertechnik) regelmäßig eine Leiterplatte auf, den Anforderungen entsprechend, insbesondere kundenspezifisch individuell, bestückt sein kann.

Die Druckschrift EP 1 326 304 A2 offenbart eine Reihenklemme, bei der die Montage der Leiterplatte in die Reihenklemme vereinfacht ist.

Die KR 101 458 621 B1, die KR 2017 0110287 A, die DE 10 2020 104620 B3 und DE 2014 001272 A1 offenbaren jeweils weitere Anschlusselemente und die DE 24 22 538 A1 offenbart ein Anschlusselement nach dem Oberbegriff des Anspruchs 1.

Aufgabe der vorliegenden Erfindung ist es, Anschlusselemente, eine Leiterplatte mit solchen Anschlusselementen und eine alternative Reihenklemme mit solchen Anschlusselementen zu schaffen, die die Montage der Leiterplatte automatisiert und noch weiter vereinfacht ermöglichen.

Die Aufgabe wird gelöst mit einem Anschlusselement mit den Merkmalen des unabhängigen Patentanspruchs 1, einer elektrischen Leiterplatte mit den Merkmalen des Patentanspruchs 12, und einer Reihenklemme mit den Merkmalen des Patentanspruchs 14. Vorteilhaft Ausführungsformen sind den abhängigen Ansprüchen entnehmbar.

Nach Anspruch 1 wird ein Anschlusselement zum Montieren einer elektrischen Leiterplatte an einen elektrischen Flachleiter, insbesondere eine Stromschiene, geschaffen. Das Anschlusselement weist eine ebene Montagefläche auf, die zum Anlegen an die Leiterplatte ausgebildet und zum Montieren des Anschlusselements an die Leiterplatte vorgesehen ist. Weiterhin weist das Anschlusselement eine Kontakttulpe zum elektrisch leitend kontaktierenden Aufnehmen des Flachleiters auf.

Das Anschlusselement zeichnet sich weiter dadurch aus, dass die Kontakttulpe wenigstens ein Klemmelement sowie ein Abstützelement umfasst. Zwischen dem Klemmelement und dem Abstützelement ist eine Aufnahme für den Flachleiter vorgesehen. Zum elektrisch leitend kontaktierenden Aufnehmen des Flachleiters wird das Anschlusselement, insbesondere die Kontakttulpe, bevorzugt, insbesondere in eine Schieberichtung, auf den Flachleiter aufgeschoben, oder wird der Flachleiter, insbesondere gegen die Schieberichtung, in die Kontakttulpe eingeschoben, wobei sich das Klemmelement in, und das Abstützelement gegen eine Schieberichtung des Anschlusselements auf den Flachleiter erstreckt .

Das Klemmelement in und das Abstützelement sind somit gegensinnig gerichtet, was in besonders vorteilhaft realisierbaren Ausgestaltungen resultiert, welche das Kontaktieren einer Leiterplatte einfach und sicher machen.

Nach Anspruch 1 zeichnet sich das Anschlusselement weiter noch dadurch aus, dass sich die Kontakttulpe in einem Montagewinkel größer als **45°** und kleiner als **135°** zur Montagefläche erstreckt. Dadurch kann das Anschlusselement im Montagewinkel auf den Flachleiter, oder der Flachleiter im Montagewinkel in die Kontakttulpe geschoben werden. Vorzugsweise wird der Flachleiter dabei in der Kontakttulpe verklemmt.

Um mehrere, insbesondere zueinander gedrehter, Anschlusselemente in demselben Montagewinkel gleichzeitig auf Flachleiter montieren zu können, ist es bevorzugt, dass der Montagewinkel ein etwa rechter Winkel ist. Bei dieser Ausführungsform erstreckt sich die Kontakttulpe in einem etwa rechten Montagewinkel zur Montagefläche.

Das Anschlusselement ermöglicht nicht nur ein elektrisch leitendes Verbinden des Flachleiters mit der Leiterplatte. Sondern zudem ermöglicht es eine Montage der Leiterplatte durch Aufschieben der Kontakttulpe auf den Flachleiter.

Dabei ist es bevorzugt, dass am Klemmelement ein Rastmittel zum Verrasten des Anschlusselementes mit dem Flachleiter vorgesehen ist. Dadurch ist die Leiterplatte auch unter Vibrationsbelastung sicher am Flachleiter montiert. In dieser Ausführungsform weist der Flachleiter bevorzugt ein Gegenrastmittel auf, das mit dem Rastmittel am Klemmelement zusammenwirkt. Dadurch sind das Anschlusselement sowie der Flachleiter miteinander verklemmbar und/oder verrastbar.

Das Abstützelement erstreckt sich bevorzugt von der Montagefläche ausgehend zu einem freien Ende hin. Es ist an einem Abstützende der Montagefläche an dieser angeordnet. Im montierten Zustand dient es wenigstens abschnittsweise als Anlagefläche und als erstes Kontakttulpenelement zum Kontaktieren des bzw. für den Flachleiter

Nach einer weiter bevorzugten Ausgestaltung kann dann ergänzend vorzugsweise vorgesehen sein, dass sich das Klemmelement zu einem von der Montagefläche abgewandt ausgerichteten freien Ende hin erstreckt, also quasi gegengerichtet zum Abstützelement bzw. ersten Kontakttulpenelement. Die beiden Kontakttulpenelemente sind somit bevorzugt gegensinnig gerichtet, was in besonders vorteilhaft realisierbaren Ausgestaltungen resultiert, welches das Kontaktieren einer Leiterplatte einfach und sicher machen.

An einem dem Abstützelement abgewandten Verbindungsende der Montagefläche weist das Anschlusselement zudem bevorzugt einen Verbindungsarm auf. Am Verbindungsarm, insbesondere an einem Kontaktende des Verbindungsarms, ist das Klemmelement angeordnet. Dabei kann mehr als ein, insbesondere können zwei Klemmelemente nebeneinander, am Verbindungsarm angeordnet sein. Die Montagefläche ist daher durch den Verbindungsarm mit dem Klemmelement verbunden. Dabei ist es bevorzugt, dass der Verbindungsarm das Abstützelement übergreift und vom freien Ende des Abstützelements beabstandet ist. Das Klemmelement ist, insbesondere dadurch, federnd nachgiebig am Verbindungsarm angeordnet. Es ist gegen eine Rückstellkraft relativ zum Verbindungsarm schwenkbar. Dadurch erstreckt sich das Klemmelement in, und das Abstützelement gegen die Schieberichtung.

Um ein Verklemmen und/oder Verrasten des Flachleiters in der Kontakttulpe zu ermöglichen, ist es bevorzugt, dass das Kontaktelement und das Abstützelement im Wesentlichen parallel zueinander ausgerichtet sind. dabei können sowohl das Abstützelement als auch das Klemmelement wenigstens teilweise eine im Querschnitt bogenförmige, winkelige und/oder gekrümmte Kontur aufweisen. Wesentlich ist, dass der Flachleiter in die Kontakttulpe, das heißt zwischen das Abstützelement und das Klemmelement im Montagewinkel einschiebbar und dort verklemm- und/oder verrastbar ist.

Das Klemmelement weist dafür bevorzugt eine bogenförmige Anbindung an den Verbindungsarm auf. Weiterhin ist es bevorzugt, dass der Verbindungsarm im Querschnitt bogenförmig oder winkelig ausgebildet ist.

In einer bevorzugten Ausführungsform weist der Verbindungsarm eine im Querschnitt im Wesentlichen rechtwinkelige Kontur auf. In dieser Ausführungsform ist eine Außenfläche des Verbindungsmittels etwa parallel zur Montagefläche angeordnet und von dieser beabstandet. In einem an der Leiterplatte montierten Zustand ist diese Außenfläche daher besonders gut zugänglich. Es ist bevorzugt, dass an dieser Außenfläche des Verbindungsarms ein Befestigungsmittel für einen Automatisierungsroboter vorgesehen ist, oder dass zumindest ein Teil der Außenfläche (141) das Befestigungsmittel bildet. Ganz besonders bevorzugt handelt es sich dabei um eine Saugfläche. Die Saugfläche ermöglicht ein Greifen des Anschlusselementes im montierten Zustand, in dem dieses an der Leiterplatte befestigt ist. Dadurch kann die Leiterplatte mit dem Automatisierungsroboter montiert werden.

Zum Montieren des Anschlusselementes an die elektrische Leiterplatte ist zudem bevorzugt am Anschlusselement ein Montagemittel vorgesehen. Dabei kann es sich in einer bevorzugten Ausführungsform um eine Durchgangsbohrung handeln, die die Montagefläche durchsetzt. Das Anschlusselement ist dann beispielsweise durch Löten und/oder Schrauben oder Nieten an der Leiterplatte befestigbar. Bevorzugt erfolgt eine Befestigung im Lötautomaten (Reflow); optional oder alternativ durch anderes Befestigen wie Nieten oder Schrauben oder dgl.. Vorzugsweise ist es im montierten Zustand elektrisch leitend mit einer Leitbahn oder Leitfläche der Leiterplatte verbunden.

Dabei ist es besonders bevorzugt, dass das Anschlusselement einstückig gefertigt ist, insbesondere aus einem elektrisch leitenden Flachbandmaterial. In einer ganz besonders bevorzugten Ausführungsform ist es als Stanzbiegebauteil sehr schnell und kostengünstig herstellbar. Dafür wird bevorzugt ein elektrisch leitendes Metall oder eine elektrisch leitende Metalllegierung verwendet. Im montierten Zustand ist das Anschlusselement bevorzugt zum elektrisch leitenden Verbinden des Flachleiters mit der Leiterbahn oder Leitfläche der Leiterplatte vorgesehen.

Die Aufgabe wird weiterhin gelöst mit einer elektrischen Leiterplatte mit einem solchen Anschlusselement. Dabei ist es bevorzugt, die Montagefläche des Anschlusselementes flächig an der Leiterplatte anliegt. Vorzugsweise liegt sie flächig an einer Leiterbahn oder einer Leitfläche der Leiterplatte an und kontaktiert diese elektrisch leitend.

Weiterhin bevorzugt sind die Montagefläche und/oder das Abstützelement bündig mit einem Rand der Leiterplatte angeordnet. Dadurch erstreckt sich das Kontaktelement neben der Leiterplatte. Dadurch wird die Leiterplatte beim Aufschieben des Anschlusselementes, insbesondere der Kontakttulpe, auf den Flachleiter neben diesem angeordnet.

Die Aufgabe wird weiterhin gelöst mit einer Reihenklemme, insbesondere in anreihbarer Auslegung, mit einem, insbesondere anreihbaren, Isolierstoffgehäuse, in dem eine Anschlussvorrichtung zum Anschluss eines elektrischen Leiters angeordnet ist, mit einem Flachleiter, beispielsweise einer Stromschiene, und mit einer solchen, insbesondere ersten, elektrischen Leiterplatte. Vorzugsweise weist die Reihenklemme mindestens zwei oder noch mehr Anschlussvorrichtungen auf, so dass mehrere elektrische Leiter an die Reihenklemme anschließbar sind. Weiterhin ist es bevorzugt, dass die Anschlussvorrichtungen jeweils eine Stromschiene aufweisen. Vorzugsweise sind wenigstens zwei der Stromschienen oder mehr, insbesondere alle, auf ein an der Leiterplatte befestigtes Anschlusselement aufschiebbar. Dadurch sind die in die Anschlussvorrichtungen eingesteckten elektrischen Leiter mit der Leiterplatte elektrisch leitend verbindbar.

Die Leiterplatte, insbesondere das an der Leiterplatte befestigte Anschlusselement, ermöglicht eine vollautomatische Montage der Reihenklemme. Dabei können das Isolierstoffgehäuse, oder mindestens eine Gehäuseschale des Isolierstoffgehäuses, mit den Anschlussvorrichtungen für die elektrischen Leiter sowie mit dem Flachkontakt, insbesondere der Stromschiene, und/oder weitere mechanische Bauteile vorgefertigt sein. Die Montage der Leiterplatte mit einer gegebenenfalls an der Leiterplatte angeordneten Elektronik kann erst spät im Montageprozess erfolgen. Dies vereinfacht die Handhabung von Leiterplatten verschiedener, insbesondere individueller, Ausführungsformen. Zudem können eine Prüfung der Leiterplatte, insbesondere der Elektronik, mit der die Leiterplatte bestückt ist, sowie ihre Reparatur erst spät im Montageprozess erfolgen. Weiterhin sind die Anschlussvorrichtungen auch noch nach Montage der Leiterplatte querverbindbar. Es handelt sich vorzugsweise um eine interne Querverbindung - also innerhalb des Gehäuses. Das findet bei Gehäusen aus mehreren Scheiben statt. Die Querverbindung wird dann beim Zusammenfügen der einzelnen Scheiben ggf. über ein Zusatzelement hergestellt.

Zum Verklemmen und/oder Verrasten mit dem Anschlusselement weist dieses ein Rastmittel auf, welches vorzugsweise an der Kontakttulpe, insbesondere am Klemmelement, angeordnet ist. Der Flachleiter weist dafür bevorzugt ein Gegenrastmittel auf, das im montierten Zustand mit dem Rastmittel zusammenwirkt.

Weiterhin bevorzugt ist in dem Isolierstoffgehäuse, insbesondere in einer Gehäuseschale des Isolierstoffgehäuses, eine Aussparung zur Aufnahme der elektrischen Leiterplatte vorgesehen. Vorzugsweise weist diese Aussparung eine der Kontur der Leiterplatte angepasste Form auf.

Um eine beim Montieren des Anschlusselementes an den Flachleiter bewirkte Relativbewegung zu verhindern, ist es weiterhin bevorzugt, dass das Isolierstoffgehäuse ein Anschlagmittel, insbesondere einen Stift, und die Leiterplatte ein Gegenanschlagmittel aufweisen, insbesondere eine Durchgangsbohrung, die zusammenwirken. Das Anschlagmittel ist in einer bevorzugten Ausführungsform als Stift ausgebildet, wobei das Gegenanschlagmittel als Durchgangsbohrung ausgebildet ist, oder umgekehrt. Dabei sind die Konturen und/oder Ausmaße der Durchgangsbohrung und des Stiftes so aufeinander abgestimmt, dass der Stift genau in die Durchgangsbohrung passt und die Relativbewegung verhindert.

In einer weiteren bevorzugten Ausführungsform ist die Reihenklemme zwei- oder mehrschalig aufgebaut. Dabei weist sie bevorzugt eine erste Gehäuseschale mit einer Aussparung zur Aufnahme der, insbesondere ersten, Leiterplatte, auf, sowie eine zweite Gehäuseschale mit einer Aussparung zur Aufnahme einer zweiten Leiterplatte. Diese Ausführungsform ermöglicht das Anordnen von erheblich mehr Anschlussvorrichtungen und/ oder eine erheblich komplexere Elektronik der Reihenklemme. Um die elektrischen Komponenten der Reihenklemme, insbesondere die Anschlussvorrichtungen und/oder die Flachleiter, voneinander elektrisch zu isolieren, ist es bevorzugt, dass zwischen den Gehäuseschalen eine Isolierwand angeordnet ist.

Weiterhin können an den Gehäuseschalen elektrische Verbindungsmittel und dazu korrespondierend ausgebildete Gegenverbindungsmittel, die elektrisch leitend zusammenwirken, befestigt sein, die zum Verbinden von Leiterbahnen und/oder Leitflächen der ersten und zweiten Leiterplatte vorgesehen sind. Um ein einfaches und schnelles Verbinden der zusammenwirkenden Verbindungsmittel der beiden Gehäuseschalen durch Aufstecken zu ermöglichen, können in der Isolierwand gezielt Ausbruchflächen vorgesehen sein, so dass das Aufstecken nach Ausbrechen der Ausbruchfläche durch die dabei entstehende Durchgangsfläche möglich ist. Die Ausbruchflächen können weiterhin dazu genutzt werden, die Leiterplatten mit Bauteilen zu bestücken, die dicker als die Gehäuseschalen sind. Nach Ausbrechen der Ausbruchfläche können diese Bauteile durch die entstehende Durchgangsfläche in die gegenüberliegende Gehäuseschale hineinragen.

Diese Montage der elektrischen Leiterplatte ist spät in dem Montageprozess der Reihenklemme möglich. Insbesondere können alle mechanischen Bauteile der Reihenklemme vor der Montage der Leiterplatte bereits vormontiert sein. Die Montage der Reihenklemme kann zudem vollautomatisch erfolgen.

Im Folgenden wird die Erfindung anhand von Figuren beschrieben. Die Figuren sind lediglich beispielhaft und schränken den allgemeinen Erfindungsgedanken nicht ein. Es zeigen:
- Figur 1: einen Ausschnitt aus einer Reihenklemme mit einer Leiterplatte, an der ein Anschlusselement befestigt ist, in einer perspektivischen Ansicht;
- Figur 2: in (a) - (c) jeweils einen Ausschnitt aus einer Reihenklemme mit einer Leiterplatte, an der ein Anschlusselement einer weiteren Ausführungsform befestigt ist, in einer perspektivischen Ansicht, in (d) eine Gehäuseschale der Reihenklemme in einer perspektivischen Ansicht, in (e) eine Leiterplatte mit mehreren an der Leiterplatte befestigten Anschlussvorrichtungen der Ausführungsform der Fig. 2 (a) - (c) in einer perspektivischen Ansicht, und in (f) die Gehäuseschale der Fig. 2 (d) beim Montieren der Leiterplatte der Fig. 2 (e);
- Figur 3: in (a) und (b) jeweils eine Gehäuseschale einer zweischaligen Reihenklemme mit montierter Leiterplatte in einer perspektivischen Ansicht, in (c) die Gehäuseschalen der Fig. 3 (a) und (b) sowie eine Isolierwand in einer explosionsartigen Ansicht, und in (d) die montierte zweischalige Reihenklemme; und
- Figur 4: in (a) einen Ausschnitt aus einer zweischaligen Reihenklemme, und in (b) einen Ausschnitt aus einer Gehäuseschale einer weiteren Ausführungsform einer Reihenklemme.

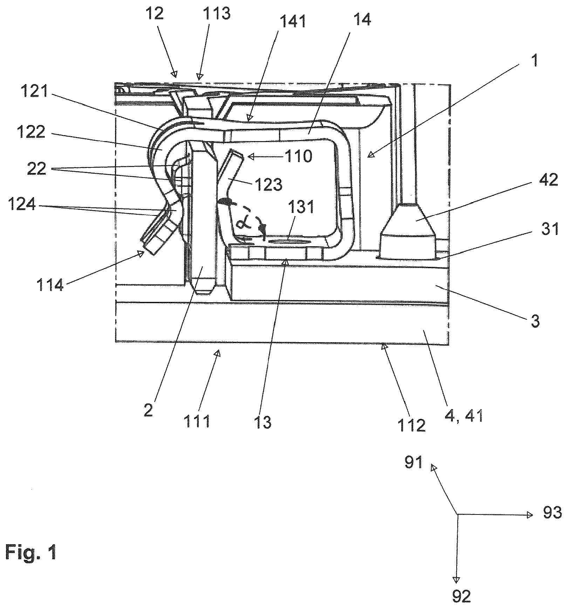

Fig. 1 zeigt einen Ausschnitt aus einer Reihenklemme 4, mit einer Leiterplatte, an der ein Anschlusselement 1 befestigt ist, das zum Montieren der elektrischen Leiterplatte 3 an einen elektrischen Flachleiter 2 vorgesehen ist. Das Anschlusselement 1 ist einstückig als Stanzbiegebauteil gefertigt. Es ist aus einem elektrisch gut leitfähigen Material gefertigt. Als Flachleiter 2 kann beispielsweise eine ebenfalls aus einem gut leitfähigen Material gefertigte Stromschiene dienen. Im Folgenden werden die Begriffe Flachleiter 2 und Stromschiene daher synonym verwendet.

Zum Montieren des Anschlusselements 1 auf die elektrische Leiterplatte 3 weist das Anschlusselement 1 eine ebene Montagefläche 13 auf. Die Montagefläche 13 ist zum flächigen Anlegen an die Leiterplatte 3 vorgesehen. Um das Anschlusselement 1 an der Montagefläche 13 zu befestigen, weist das Anschlusselement 1 ein Montagemittel 131 in Form einer Durchgangsbohrung auf. Dadurch kann das Anschlusselement 1 an der Leiterplatte 3 beispielsweise durch Löten und/oder ggf. Nieten oder Schrauben befestigt werden. Zudem ist das Anschlusselement 1 auf eine Leiterbahn (nicht gezeigt) der Leiterplatte 3 aufgelötet, so dass es elektrisch leitend mit der Leiterbahn der Leiterplatte 3 verbunden ist.

Das Kontaktelement könnte alternativ auch so verwendet werden, dass Stromschiene und Leiterplatte parallel angeordnet sind. In Fig. 1: Die Leiterplatte würde z.B. senkrecht stehen und auf die rechte Seite des Kontaktelementes angelötet werden. Die entsprechende Seite des Kontaktelements würde dann entsprechend ausgestaltet.

Weiterhin weist das Anschlusselement 1 eine Kontakttulpe 12 auf, die zum elektrisch leitend kontaktierenden Aufnehmen des Flachleiters 2 ausgebildet ist. Die Kontakttulpe 12 weist dafür zwei nebeneinander angeordnete Klemmelemente 121, 122 und ein Abstützelement 123 auf. Der Flachleiter 2 ist zwischen den Klemmelementen 121, 122 und dem Abstützelement 123 einschiebbar. Dafür ist entweder das Anschlusselement 1 in eine Schieberichtung 92 auf den Flachleiter 2 aufschiebbar, oder der Flachleiter 2 gegen die Schieberichtung 92 in die Kontakttulpe 12 einschiebbar.

Die Kontakttulpe 12 ist hier in einem im Wesentlichen rechten Montagewinkel α zur Montagefläche 13 ausgerichtet. Die Schieberichtung 92 erstreckt sich daher im Wesentlichen quer zur Montagefläche13, die durch eine erste Linie (nicht gezeigt), welche sich in eine erste Erstreckungsrichtung 91 quer zur Schieberichtung 92 erstreckt, und durch eine zweite Linie (nicht gezeigt), welche sich in einer zweite Erstreckungsrichtung 93 quer zur Schieberichtung 92 und quer zur ersten Erstreckungsrichtung 91 erstreckt, aufgespannt ist. Im montierten Zustand, in dem der Flachleiter 2 in die Kontakttulpe 12 aufgenommen ist, ist der Flachleiter 2 zwischen den Klemmelementen 121, 122 und dem Abstützelement 123 verklemmt.

Um ein Lösen des Anschlusselementes 1 vom Flachleiter 2, insbesondere auch unter Vibrationsbedingungen, sicher zu verhindern, weisen die Klemmelemente 121, 122 Rastmittel 124 auf, wobei der Flachleiter 2 Gegenrastmittel 22 aufweist, die mit den Rastmitteln 124 zusammenwirken. Die Rastmittel 124 sind hier jeweils durch eine im jeweiligen Klemmelement 121, 122 vorgesehene Biegung gebildet. Als Gegenrastmittel 22 sind Erhebungen am Flachleiter 2 angeordnet. Im montierten Zustand sind die Biegungen 124 in Schieberichtung 92 unterhalb der Erhebungen 22 angeordnet, so dass das Anschlussmittel 1 nicht gegen die Schieberichtung 92 verschiebbar ist. Dadurch sind das Anschlusselement 1 und der Flachleiter 2 im montierten Zustand nicht nur miteinander verklemmt, sondern zudem miteinander verrastet, und das Lösen des Anschlusselementes 1 vom Flachleiter 2 wird sicher verhindert.

Das Abstützelement 123 ist an einem Abstützende 111 der Montagefläche 13 an dieser angeordnet und erstreckt sich von der Montagefläche 13 ausgehend bis zu einem freien Ende 110. Es weist in der gezeigten Ausführungsform eine Biegung (nicht bezeichnet) auf, mit der es im montierten Zustand am Flachleiter 2 anliegt.

An einem dem Abstützelement 123 abgewandten Verbindungsende 112 der Montagefläche 13 ist weiterhin ein Verbindungsarm 14 angeordnet, der zum Verbinden der Montagefläche 13 mit den Klemmelementen 121, 122 vorgesehen ist. Die Klemmelemente 121, 122 sind an einem dem Verbindungsende 112 gegenüberliegenden Kontaktende 113 des Verbindungsarms 14 angeordnet. Dabei übergreift der Verbindungsarm 14 das Abstützelement 123, so dass die Klemmelemente 121, 122 an einer der Montagefläche abgewandten Seite (nicht bezeichnet) des Abstützelementes 123 angeordnet sind. Es ist etwa bogenförmig an den Verbindungsarm 14 angebunden. Dadurch ist das Klemmelement im Montagewinkel α zur Montagefläche 13 ausgerichtet und federnd nachgiebig am Verbindungsarm 14 angeordnet. Es ist gegen eine Rückstellkraft relativ zum Verbindungsarm 14 schwenkbar. Die Kontaktelemente 121, 122 erstrecken sich jeweils bis zu einem freien Klemmende 114, das vom Abstützelement 123 weggebogen ist. Dadurch kann der Flachleiter 2 beim Aufschieben des Anschlusselementes 1 leicht in die Kontakttulpe 12 gleiten.

Der Verbindungsarm 14 weist eine im Querschnitt im Wesentlichen rechtwinkelige Form auf. Dadurch weist er eine etwa parallel zur Montagefläche 13 angeordnete Außenfläche 141 auf, die als Befestigungsmittel für einen Automatisierungsroboter (nicht gezeigt) dient. Dabei handelt es sich um eine Saugfläche, die ein Greifen des Anschlusselementes 1 ermöglicht, so dass der Automatisierungsroboter die Leiterplatte 3 mit dem Anschlusselemente 1 vollautomatisch in eine Reihenklemme 4 montieren kann.

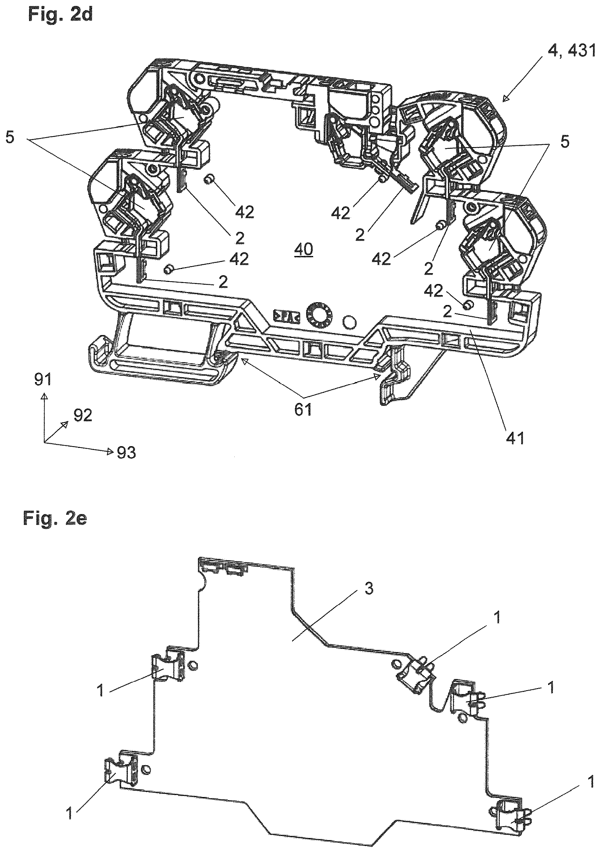

Die elektrische Leiterplatte 3, an der das Anschlusselement 1 befestigt ist, ist in einer Aussparung 40 (s. Fig. 2(d)) einer Reihenklemme 4 angeordnet. An einem Isolierstoffgehäuse 41 der Reihenklemme 4 ist ein Stift 42 vorgesehen, der als Anschlagmittel für die Leiterplatte 3 dient. Der Stift 42 durchsetzt dafür eine Durchgangsbohrung 31, die in der Leiterplatte 3 angeordnet ist, und als Gegenanschlagmittel vorgesehen ist. Durch den Stift 42 wird eine beim Montieren des Anschlusselementes 1 an den Flachleiter 2 und/oder durch die Rückstellkraft der Klemmelemente 121, 122 bewirkte Relativbewegung der Leiterplatte 3 zum Isolierstoffgehäuse 41 verhindert.

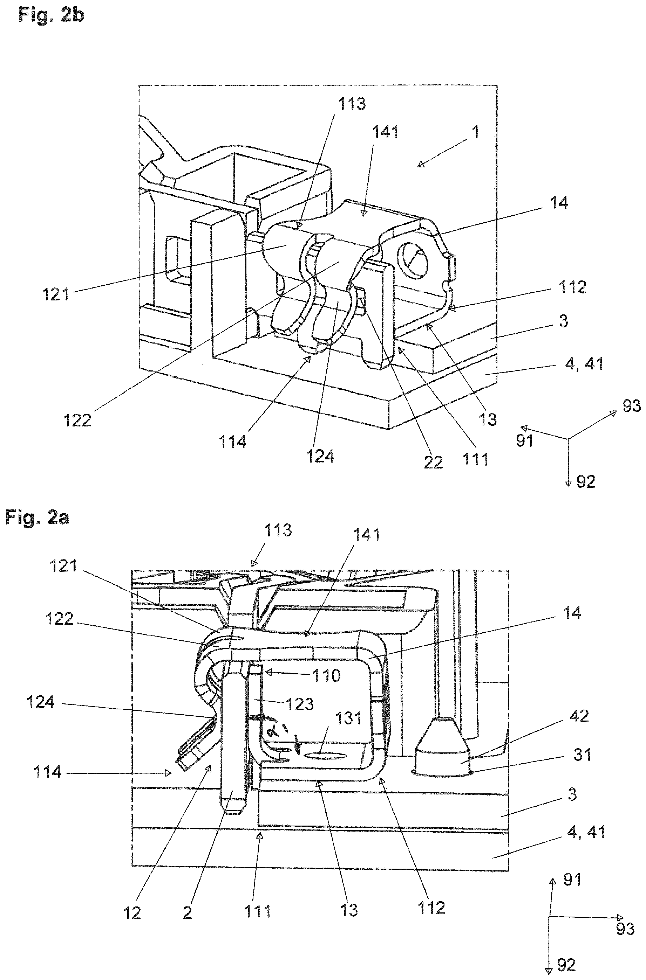

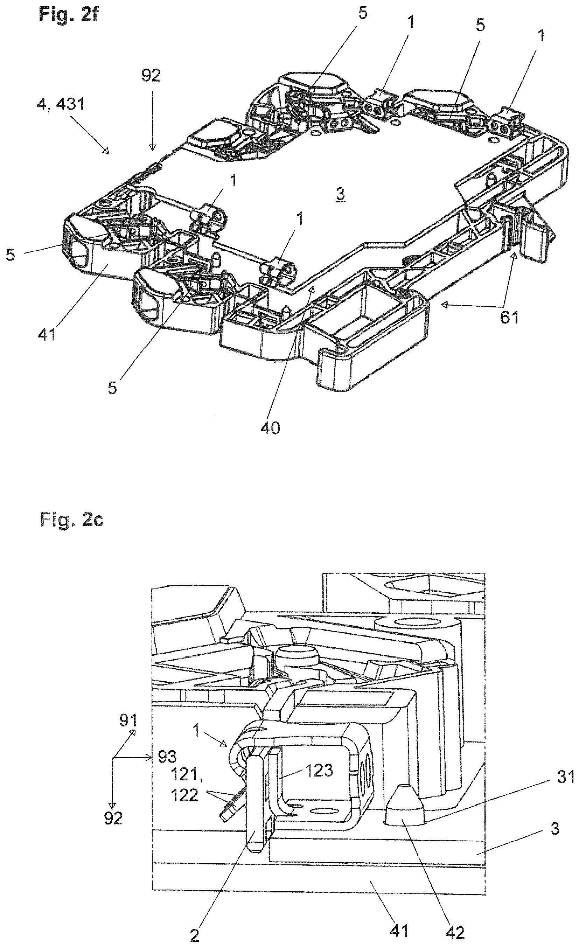

Fig. 2 zeigt in (a) - (c) jeweils einen Ausschnitt aus der Reihenklemme 4 mit der Leiterplatte 3, an der ein Anschlusselement 1 einer weiteren Ausführungsform befestigt ist, in einer perspektivischen Ansicht, in (d) eine Gehäuseschale 431 der Reihenklemme 4 in einer perspektivischen Ansicht, in (e) eine Leiterplatte 3 mit mehreren an der Leiterplatte 3 befestigten Anschlussvorrichtungen 1 der Ausführungsform der Fig. 2 (a) - (c) in einer perspektivischen Ansicht, und in (f) die Gehäuseschale 431 der Fig. 2 (d) beim Montieren der Leiterplatte 3 der Fig. 2 (e).

Das Anschlusselement 1 unterscheidet sich von dem Anschlusselement 1 der Fig. 1 durch die Form des Abstützelementes 123, welches hier geradlinig in dem insbesondere rechten Montagewinkel α zur Montagefläche 13 verläuft. Weiterhin unterscheidet sich der in der Reihenklemme 4 angeordnete Flachleiter 2 von dem Flachleiter 2 der Fig. 1 durch das Gegenrastmittel 22, das hier durch eine Einbuchtung in Form einer Nut gebildet ist. Bei dieser Ausführungsform verrasten die als Biegung ausgebildeten Rastmittel 124 der Klemmelemente 121, 122 in der Nut. Dabei wird der Flachleiter 2 flächig gegen das Abstützelement 123 gedrückt und dadurch zudem verklemmt.

An der in Fig. 2 (e) dargestellten Leiterplatte 3 sind mehrere zueinander in der ersten und/oder zweiten Erstreckungsrichtung 91, 93 versetzte und verdrehte Anschlusselemente 1 auf. Jedem der Anschlusselemente 1 ist jeweils ein als Stift 42 ausgebildetes Anschlagmittel zugeordnet, der beim Montieren der Leiterplatte 3 in die Reihenklemme 4 durch die zu ihm korrespondierende Durchgangsbohrung 31 geführt wird, und dadurch eine Relativbewegung der Leiterplatte 3 zum Isolierstoffgehäuse 41 der Reihenklemme 4 verhindert.

Die Reihenklemme 4 ist in Fig. 2 (d) dargestellt. Sie weist ein Isolierstoffgehäuse 41 auf, in dem eine Vielzahl Anschlussvorrichtungen 5 angeordnet sind, die jeweils zum Anschließen eines elektrischen Leiters (nicht gezeigt) an eine Stromschiene 2 vorgesehen sind. Im Isolierstoffgehäuse 41 ist eine Aussparung 40 als Aufnahme für die Leiterplatte 3 vorgesehen. Die Stromschienen 2 erstrecken sich jeweils bis zur Aussparung 40. Weiterhin sind in der Aussparung 40 für jedes Anschlusselement 1, oder für jede Stromschiene 2, jeweils ein Stift 42 als Anschlagmittel angeordnet.

Sichtbar ist hier weiterhin, dass am Isolierstoffgehäuse 41 Mittel 61 zum Aufrasten der Reihenklemme 4 an eine insbesondere hutförmige Schiene (nicht gezeigt) vorgesehen sind.

Fig. 2 (f) zeigt das Montieren der Leiterplatte 3 in die Aussparung 40 des Isolierstoffgehäuses 41. Dabei wird die Leiterplatte 3 in Schieberichtung 92 in die Aussparung 40 eingeschoben. Dabei werden die Anschlusselemente 1 jeweils im Montagewinkel α auf einen der Flachleiter 2aufgeschoben, so dass die Flachleiter 2 jeweils in die Kontakttulpe 12 einer der Anschlusselemente 1 aufgenommen werden, und zwischen dessen Abstützelement 123 und dessen Klemmelementen 121, 122 verklemmt und/der verrastet werden.

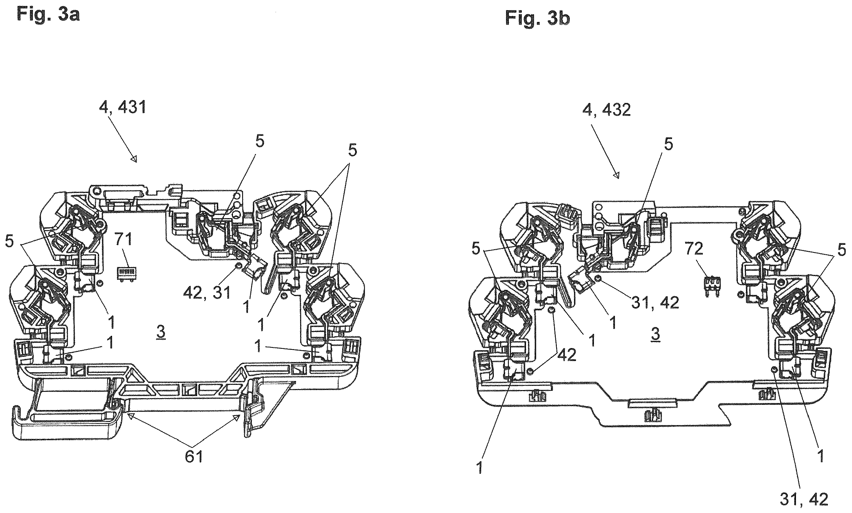

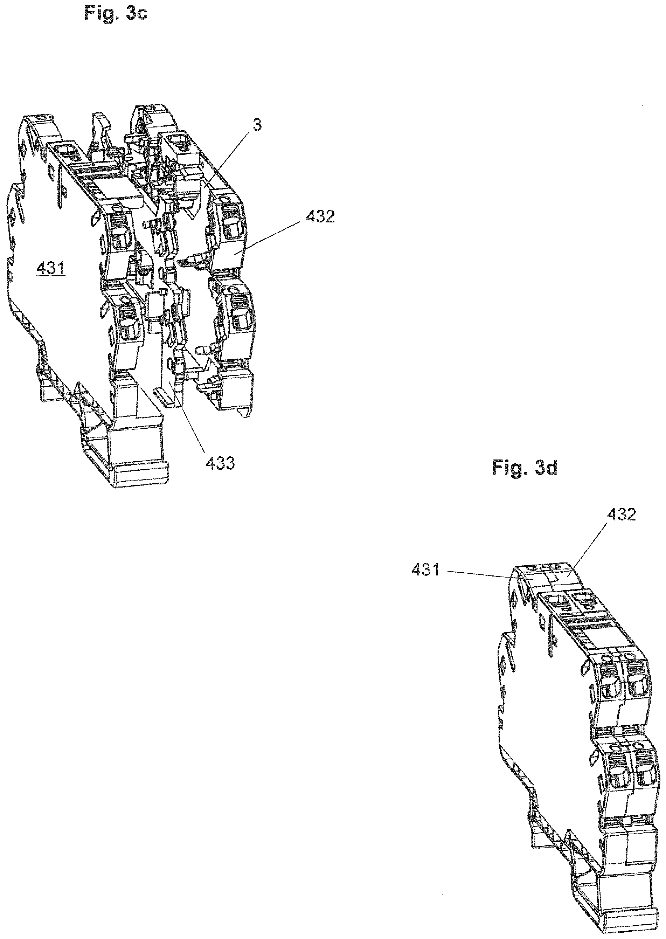

In Fig. 3 ist eine zweischalige Reihenklemme 4 dargestellt. Die Reihenklemme 4 weist eine erste Gehäuseschale 431 auf, die Fig. 3 (a) zeigt, sowie eine zweite Gehäuseschale 432, die Fig. 3 (b) zeigt. Die Gehäuseschalen sind korrespondierend zueinander ausgebildet, so dass sie bündig aneinander montierbar sind. Die bündig aneinander montierten Gehäuseschalen 431, 432, das heißt die vollständig montierte Reihenklemme, zeigt Fig. 3 (d). In der in Fig. 3 (c ) gezeigten explosionsartigen Ansicht der Reihenklemme 4 ist sichtbar, dass zwischen den beiden Gehäuseschalen 431, 432 eine Isolierwand 433 angeordnet ist.

Sichtbar ist, dass in jeder der beiden Gehäuseschalen 431, 432 jeweils mehrere Anschlussvorrichtungen 5 zum Anschließen eines elektrischen Leiters vorgesehen sind. Die Anschlussvorrichtungen 5 weisen jeweils eine Stromschiene 2 auf. Weiterhin weist jede der beiden Gehäuseschalen 431, 432 jeweils eine Aussparung 40 auf, in die eine Leiterplatte 3 mit den an ihr befestigten Anschlusselementen 1 montiert ist.

Dabei ist jeder der Anschlussvorrichtungen 5, beziehungsweise jeder Stromschiene 2, jeweils ein Anschlusselement 1 zugeordnet. Die Leiterplatten 3 sind jeweils durch Aufschieben der Anschlusselemente 1 auf die ihnen zugeordneten Stromschienen 2 montiert. Auch hier sind wieder den Anschlusselementen 1 zugeordnete Stifte 42 als Anschlagmittel vorgesehen, die durch Durchgangsbohrungen 31 in der Leiterplatte 3 geführt sind.

Die in die erste Gehäuseschale 431 eingelegte Leiterplatte 3 ist mit einem elektrischen Verbindungsmittel 71 bestückt, wobei die in die zweite Gehäuseschale 432 eingelegte Leiterplatte 3 mit einem dazu korrespondierend ausgebildeten Gegenverbindungsmittel 72 bestückt ist. Die Verbindungsmittel 71 und Gegenverbindungsmittel 72 sind zum elektrischen Verbinden von Leiterbahnen und/oder Leitflächen der beiden Leiterplatten 3 vorgesehen. Sie sind so platziert, dass sie sich beim aneinander Fügen der Gehäuseschalen 431, 432 elektrisch leitend kontaktieren. Um dies zu ermöglichen, ist in der Isolierwand 433 eine Ausbruchfläche (nicht gezeigt) vorgesehen, die vor dem Montieren der Reihenklemme 4 ausgebrochen wird.

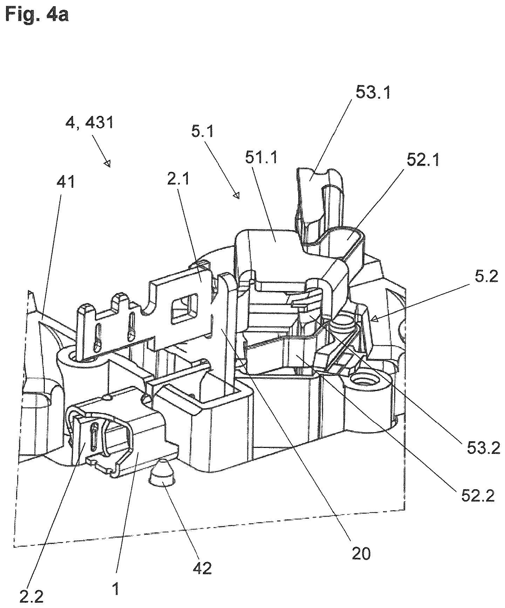

In Fig. 4 (a) ist ein Ausschnitt aus der Reihenklemme 4 der Fig. 3 dargestellt. Die Isolierwand 433 ist hier nicht gezeigt.

Sichtbar sind einander gegenüberliegend angeordnet Anschlussvorrichtungen 5.1, 5.2, die als Federkraftklemmen ausgebildet sind. Sie weisen jeweils einen Klemmkäfig 51.1 auf, in dem eine Klemmfeder 52.1, 52.2 angeordnet ist, mit der ein in die Anschlussvorrichtung 5.1, 5.2 eingeführter elektrischer Leiter an einer der Anschlussvorrichtung 5.1, 5.2 zugeordneten Stromschiene 2.1, 2.2 diese elektrisch kontaktierend verklemmbar ist. Zum Lösen des elektrischen Leiters aus der Anschlussvorrichtung 5.1, 5.2 ist jeweils ein Betätigungsmittel 53.1, 53.2 vorgesehen, das die Klemmfeder 52.1, 52.2 durch Verschieben betätigt, so dass sich diese gegen ihre Rückstellkraft verstellt und die Klemmung des elektrischen Leiters zwischen der Stromschiene 2.1, 2.2 und der Klemmfeder 52.1, 52.2 aufgehoben wird. Sichtbar ist hier eine Verbindungsschiene 20, die die beiden Stromschienen 2.1, 2.2 der benachbarten Anschlussvorrichtungen 5.1, 5.2 elektrisch leitend miteinander verbindet.

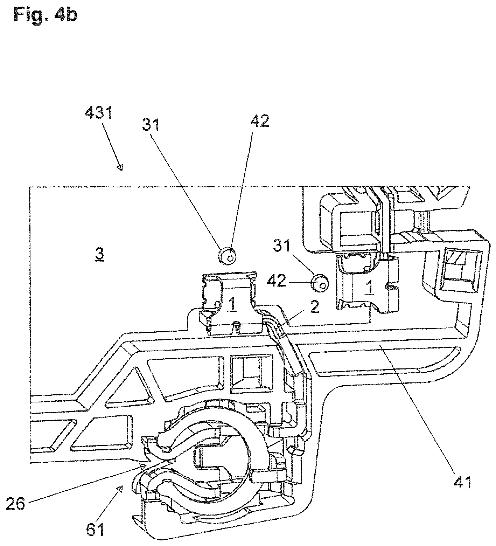

Fig. 4 (b) zeigt eine Gehäuseschale 431 einer Reihenklemme 4, die ein Mittel 61 zum Aufrasten der Reihenklemme 4 auf eine Schiene (nicht gezeigt) aufweist. Bei dieser Ausführungsform der Reihenklemme 4 ist eine der Stromschienen 2, an der die Leiterplatte 3 mittels eines Anschlusselementes 1 montiert wird, einem Funktionserdkontakt 26 zugeordnet, der zum Erden der Schiene vorgesehen ist.

### Bezugszeichen

- 1: Anschlusselement
- 110: Freies Ende
- 111: Abstützende
- 112: Verbindungsende
- 113: Kontaktende
- 114: Klemmende
- 12: Kontakttulpe
- 121, 122: Klemmelement
- 123: Abstützelement
- 124: Rastmittel
- 13: Montagefläche
- 131: Montagemittel, Durchgangsbohrung
- 14: Verbindungsmittel
- 141: Außenfläche, Saugfläche
- 2, 2.1, 2.2: Flachleiter, Stromschiene
- 20: Verbindungsschiene
- 22: Gegenrastmittel, Erhebung, Einbuchtung
- 26: Funktionserdkontakt
- 3: Leiterplatte
- 31: Gegenanschlagmittel, Durchgangsbohrung
- 4: Reihenklemme
- 40: Aussparung
- 41: Isolierstoffgehäuse
- 42: Anschlagmittel, Stift
- 431, 432: Erste, zweite Gehäuseschale
- 433: Isolierwand
- 5, 5.1, 5.2: Anschlussvorrichtung
- 51.1: Kontaktkäfig
- 52.1, 52.2: Klemmfeder
- 53.1, 53.2: Betätigungselement
- 61: Mittel zum Aufrasten der Reihenklemme auf eine Schiene
- 71, 72: Verbindungsmittel, Gegenverbindungsmittel
- A: Montagewinkel
- 91: Erste Erstreckungsrichtung
- 92: Schieberichtung
- 93: Zweite Erstreckungsrichtung

## Patentansprüche

1. Anschlusselement (1) zum Montieren einer elektrischen Leiterplatte (3) an einen elektrischen Flachleiter (2), insbesondere eine Stromschiene, mit einer ebenen oder im Wesentlichen ebenen Montagefläche (13) zum Anlegen und Montieren des Anschlusselements (1) an die Leiterplatte (3), und mit einer Kontakttulpe (12) zum elektrisch kontaktierenden Aufnehmen des Flachleiters (2), wobei die Kontakttulpe (12) wenigstens ein Klemmelement (121, 122) sowie ein Abstützelement (123) umfasst, zwischen denen eine Aufnahme für den Flachleiter (2) vorgesehen ist, wobei sich das Klemmelement (121,122) in und das Abstützelement (123) gegen eine Schieberichtung (92) des Anschlusselements (1) auf den Flachleiter (2) erstreckt, **dadurch gekennzeichnet, dass** sich die Kontakttulpe (12) in einem Montagewinkel (α) größer als 45° und kleiner als 135° zur Montagefläche (13) erstreckt, insbesondere in einem etwa rechten Montagewinkel (α).

2. Anschlusselement (1) nach Anspruch 1 **dadurch gekennzeichnet, dass** am Klemmelement (121, 122) ein Rastmittel (124) zum Verklemmen und/oder Verrasten des Anschlusselementes (1) mit dem Flachleiter (2) vorgesehen ist.

3. Anschlusselement (1) nach einem der vorherigen Ansprüche, **dadurch gekennzeichnet, dass** das Abstützelement (123) sich von der Montagefläche (13) ausgehend im Montagewinkel (α) zu einem freien Ende (110) hin erstreckt.

4. Anschlusselement (1) nach einem der vorherigen Ansprüche, **dadurch gekennzeichnet, dass** sich das Klemmelement zu einem von der Montagefläche (13) abgewandt ausgerichteten freien Ende (114) hin erstreckt.

5. Anschlusselement (1) nach einem der vorherigen Ansprüche, **dadurch gekennzeichnet, dass** es an einer vom Abstützelement (123) abgewandten Seite der Montagefläche (13) einen Verbindungsarm (14) aufweist, an dem Klemmelementes (121, 122) angeordnet ist, wobei der Verbindungsarm (14) das Abstützelement (123) übergreift und vom freien Ende des Abstützelements (123) beabstandet ist.

6. Anschlusselement (1) nach Anspruch 5, **dadurch gekennzeichnet, dass** das Klemmelement (121, 122) federnd nachgiebig am Verbindungsarm (14) angeordnet ist.

7. Anschlusselement (1) nach einem der vorherigen Ansprüche 5 oder 6, **dadurch gekennzeichnet, dass** es zwei oder mehr Klemmelemente (121, 122) aufweist, die nebeneinander am Verbindungsarm (14) angeordnet sind.

8. Anschlusselement (1) nach einem der vorherigen Ansprüche 5-7, **dadurch gekennzeichnet, dass** der Verbindungsarm (14) eine bogenförmige oder winkelige Querschnittsform aufweist, insbesondere eine etwa rechtwinkelige.

9. Anschlusselement (1) nach einem der vorherigen Ansprüche 6 bis 8, **dadurch gekennzeichnet, dass** an einer Außenfläche (141) des Verbindungsarms (14) ein Befestigungsmittel für einen Automatisierungsroboter vorgesehen ist, oder dass zumindest ein Teil der Außenfläche (141) das Befestigungsmittel bildet, insbesondere eine Saugfläche.

10. Anschlusselement (1) nach einem der vorherigen Ansprüche, **dadurch gekennzeichnet, dass** zum Montieren des Anschlusselementes (1) an die elektrische Leiterplatte (3) am Anschlusselement (1) ein Montagemittel (131) vorgesehen ist, insbesondere eine Durchgangsbohrung, die die Montagefläche (13) durchsetzt.

11. Anschlusselement (1) nach einem der vorherigen Ansprüche, **dadurch gekennzeichnet, dass** es aus einem elektrisch leitenden Flachbandmaterial einstückig gefertigt ist, insbesondere als Stanzbiegebauteil.

12. Elektrische Leiterplatte (3) mit einem Anschlusselement (1) nach einem der vorherigen Ansprüche.

13. Elektrische Leiterplatte (3) nach Anspruch 12, **dadurch gekennzeichnet, dass** die Montagefläche (13) des Anschlusselementes (1) flächig an der Leiterplatte (3) anliegt.

14. Reihenklemme (4), insbesondere in anreihbarer Auslegung,
- mit einem, insbesondere anreihbaren, Isolierstoffgehäuse (41), in dem eine Anschlussvorrichtung (5) zum Anschluss eines elektrischen Leiters angeordnet ist,
- mit einem Flachleiter (2), insbesondere einer Stromschiene (2), und
- mit einer, insbesondere ersten, elektrischen Leiterplatte (3) nach einem der Ansprüche 12-13.

15. Reihenklemme (4) nach Anspruch 14, **dadurch gekennzeichnet, dass** das Isolierstoffgehäuse (41) ein Anschlagmittel (42), insbesondere einen Stift, und die Leiterplatte (3) ein Gegenanschlagmittel (31) aufweisen, insbesondere eine Durchgangsbohrung, die zusammenwirken, um eine beim Montieren des Anschlusselementes (1) an den Flachleiter (2) bewirkte Relativbewegung zu verhindern.

16. Reihenklemme (4) nach einem der vorherigen Ansprüche 14 oder 15, **dadurch gekennzeichnet, dass** sie zweischalig aufgebaut ist, und eine erste Gehäuseschale (431) mit einer Aussparung (40) zur Aufnahme der, insbesondere ersten, Leiterplatte (3), sowie eine zweite Gehäuseschale (432) mit einer Aussparung (40) zur Aufnahme einer zweiten Leiterplatte (3) aufweist.

17. Reihenklemme (4) nach einem der vorherigen Ansprüche 14 bis 16, **dadurch gekennzeichnet, dass** zwischen den Gehäuseschalen (431, 432) eine Isolierwand (433) angeordnet ist.

## Claims

1. Connecting element (1) for mounting an electrical circuit board (3) to an electrical flat conductor (2), in particular a busbar, having a flat or substantially flat mounting surface (13) for applying and mounting the connecting element (1) to the circuit board (3), and having a contact tulip (12) for receiving the flat conductor (2) in an electrically contacting manner, wherein the contact tulip (12) comprises at least one clamping element (121, 122) and a support element (123), between which a receptacle for the flat conductor (2) is provided, wherein the clamping element (121, 122) extends in, and the support element (123) extends against, a sliding direction (92) of the connecting element (1) onto the flat conductor (2), **characterized in that** the contact tulip (12) extends at a mounting angle (α) greater than 45° and less than 135° to the mounting surface (13), in particular at an approximately right mounting angle (α).

2. Connecting element (1) according to claim 1, **characterized in that** a latching means (124) for clamping and/or latching the connecting element (1) to the flat conductor (2) is provided on the clamping element (121, 122).

3. Connecting element (1) according to one of the preceding claims, **characterized in that** the support element (123) extends from the mounting surface (13) in the mounting angle (α) towards a free end (110).

4. Connecting element (1) according to one of the preceding claims, **characterized in that** the clamping element extends toward a free end (114) oriented away from the mounting surface (13).

5. Connecting element (1) according to one of the preceding claims, **characterized in that** it has, on a side of the mounting surface (13) facing away from the support element (123), a connecting arm (14) on which clamping elements (121, 122) are arranged, wherein the connecting arm (14) engages over the support element (123) and is spaced apart from the free end of the support element (123).

6. Connecting element (1) according to claim 5, **characterized in that** the clamping element (121, 122) is arranged on the connecting arm (14) in a resiliently yielding manner.

7. Connecting element (1) according to one of the preceding claims 5 or 6, **characterized in that** it comprises two or more clamping elements (121, 122) arranged side by side on the connecting arm (14).

8. Connecting element (1) according to one of the preceding claims 5-7, **characterized in that** the connecting arm (14) has an arcuate or angular cross-sectional shape, in particular an approximately rectangular cross-sectional shape.

9. Connecting element (1) according to one of the preceding claims 6 to 8, **characterized in that** a fastening means for an automation robot is provided on an outer surface (141) of the connection arm (14), or **in that** at least a part of the outer surface (141) forms the fastening means, in particular a suction surface.

10. Connecting element (1) according to one of the preceding claims, **characterized in that** for mounting the connecting element (1) to the electrical circuit board (3), a mounting means (131) is provided on the connecting element (1), in particular a through-hole which passes through the mounting surface (13).

11. Connecting element (1) according to one of the preceding claims, **characterized in that** it is manufactured in one piece from an electrically conductive flat strip material, in particular as a stamped and bent component.

12. Electrical circuit board (3) having a connecting element (1) according to one of the preceding claims.

13. Electrical circuit board (3) according to claim 12, **characterized in that** the mounting surface (13) of the connecting element (1) lies flat against the circuit board (3).

14. Terminal block (4), in particular in a stackable design,
- having a housing (41) of insulating material, in particular a housing that is stackable, in which a connection device (5) for connecting an electrical conductor is arranged,
- having a flat conductor (2), in particular a busbar (2), and
- having an, in particular first, electrical circuit board (3) according to one of claims 12-13.

15. Terminal block (4) according to claim 14, **characterized in that** the insulating material housing (41) comprises a stop means (42), in particular a pin, and the circuit board (3) comprises a counter stop means (31), in particular a through-hole, which cooperate to prevent a relative movement caused during mounting of the connecting element (1) to the flat conductor (2).

16. Terminal block (4) according to one of the preceding claims 14 or 15, **characterized in that** it has a two-shell structure and has a first housing shell (431) with a recess (40) for receiving the, in particular first, circuit board (3), and a second housing shell (432) with a recess (40) for receiving a second circuit board (3).

17. Terminal block (4) according to one of the preceding claims 14 to 16, **characterized in that** an insulating wall (433) is arranged between the housing shells (431, 432).

## Revendications

1. Élément de connexion (1) pour le montage d'une carte de circuits électrique (3) sur un conducteur plat électrique (2), en particulier une barre collectrice, avec une surface de montage (13) plane ou sensiblement plane pour poser et monter l'élément de connexion (1) sur la carte de circuits (3), et avec une tulipe de contact (12) pour recevoir en contact électrique le conducteur plat (2), la tulipe de contact (12) comprenant au moins un élément de serrage (121, 122) et un élément d'appui (123) entre lesquels un réceptacle est prévu pour le conducteur plat (2), l'élément de serrage (121, 122) s'étendant sur le conducteur plat (2) dans un sens de translation (92) de l'élément de connexion (1) et l'élément d'appui (123) en sens inverse, **caractérisé en ce que** la tulipe de contact (12) s'étend sous un angle de montage (α) de plus de 45° et moins de 135° par rapport à la surface de montage (13), en particulier sous un angle de montage (α) à peu près droit.

2. Élément de connexion (1) selon la revendication 1, **caractérisé en ce qu'**est prévu sur l'élément de serrage (121, 122) un moyen d'enclenchement (124) pour serrer et/ou enclencher l'élément de connexion (1) avec le conducteur plat (2).

3. Élément de connexion (1) selon l'une des revendications précédentes, **caractérisé en ce que** l'élément d'appui (123) s'étend à partir de la surface de montage (13) sous l'angle de montage (α) vers une extrémité libre (110).

4. Élément de connexion (1) selon l'une des revendications précédentes, **caractérisé en ce que** l'élément de serrage s'étend vers une extrémité libre (114) orientée à l'opposé de la surface de montage (13).

5. Élément de connexion (1) selon l'une des revendications précédentes, **caractérisé en ce qu'**il présente, sur un côté de la surface de montage (13) opposé à l'élément d'appui (123), un bras de liaison (14) sur lequel l'élément de serrage (121, 122) est disposé, lequel bras de liaison (14) passe par-dessus l'élément d'appui (123) et est distant de l'extrémité libre de l'élément d'appui (123).

6. Élément de connexion (1) selon la revendication 5, **caractérisé en ce que** l'élément de serrage (121, 122) est disposé de façon souple et élastique sur le bras de liaison (14).

7. Élément de connexion (1) selon l'une des revendications 5 ou 6, **caractérisé en ce qu'**il comporte deux éléments de serrage (121, 122) ou plus qui sont disposés les uns à côté des autres sur le bras de liaison (14).

8. Élément de connexion (1) selon l'une des revendications 5 à 7, **caractérisé en ce que** le bras de liaison (14) présente une forme en section en arc de cercle ou anguleuse, en particulier à peu près en angle droit.

9. Élément de connexion (1) selon l'une des revendications 6 à 8, **caractérisé en ce qu'**est prévu sur une surface extérieure (141) du bras de liaison (14) un moyen de fixation pour un robot d'automatisation, ou **en ce qu'**au moins une partie de la surface extérieure (141) forme le moyen de fixation, en particulier une surface d'aspiration.

10. Élément de connexion (1) selon l'une des revendications précédentes, **caractérisé en ce qu'**est prévu sur l'élément de connexion (1), pour le montage de l'élément de connexion (1) sur la carte de circuits électrique (3), un moyen de montage (131), en particulier un trou traversant, qui traverse la surface de montage (13).

11. Élément de connexion (1) selon l'une des revendications précédentes, **caractérisé en ce qu'**il est fabriqué d'une seule pièce à partir d'un matériau en feuillard conducteur électrique, en particulier sous la forme d'une pièce estampée et pliée.

12. Carte de circuits électrique (3) munie d'un élément de connexion (1) selon l'une des revendications précédentes.

13. Carte de circuits électrique (3) selon la revendication 12, **caractérisée en ce que** la surface de montage (13) de l'élément de connexion (1) repose à plat sur la carte de circuits (3).

14. Borne série (4), en particulier conçue pour pouvoir être alignée,
- avec un boîtier en matériau isolant (41), pouvant en particulier être aligné, dans lequel est disposé un dispositif de connexion (5) pour la connexion d'un conducteur électrique,
- avec un conducteur plat (2), en particulier une barre collectrice (2), et
- avec une carte de circuits électrique (3) selon l'une des revendications 12-13, en particulier une première carte de circuits.

15. Borne série (4) selon la revendication 14, **caractérisée en ce que** le boîtier en matériau isolant (41) comporte un moyen formant butée (42), en particulier une goupille, et la carte de circuits (3) un moyen formant contre-butée (31), en particulier un trou traversant, qui coopèrent pour empêcher un mouvement relatif produit lors du montage de l'élément de connexion (1) sur le conducteur plat (2).

16. Borne série (4) selon l'une des revendications 14 ou 15, **caractérisée en ce qu'**elle est construite avec deux coques et comporte une première coque de boîtier (431) avec une découpe (40) destinée à recevoir la carte de circuits (3), en particulier la première carte de circuits, et une deuxième coque de boîtier (432) avec une découpe (40) destinée à recevoir une deuxième carte de circuits (3).

17. Borne série (4) selon l'une des revendications 14 à 16, **caractérisée en ce qu'**une cloison isolante (433) est disposée entre les coques de boîtier (431, 432).
